# EUROPÄISCHE PATENTANMELDUNG

(11) **EP 0 701 273 A2**
(43) Veröffentlichungstag der Anmeldung: **13.03.1996**
(21) Anmeldenummer: 95114061.5
(22) Anmeldetag: 07.09.1995
(51) Int. Cl.: H01L 21/285

(54) **Verfahren zum Sputtern von Siliziden bei der Herstellung von hochintegrierten Schaltungen**

(30) Priorität: 08.09.1994 DE 4431999
(71) Anmelder: SIEMENS AKTIENGESELLSCHAFT, D-80333 München (DE)
(72) Erfinder: Helneder, Johann, D-85652 Landsham (DE)

(57) **Zusammenfassung**

In einer Prozeßkammer, die ein zu beschichtendes Halbleitersubstrat und ein Sputtertarget aus Metall enthält, erfolgt eine CVD-Abscheidung von Silizium aus der Gasphase, wobei durch gleichzeitiges oder nachfolgendes Sputtern von dem Metalltarget eine amorphe Silizidschicht hergestellt wird.

## Beschreibung

Die Erfindung betrifft ein Verfahren zum Sputtern von Siliziden bei der Herstellung von hochintegrierten Schaltungen auf einem Halbleitersubstrat.

Zum Stand der Technik wird auf D. Widmann, H. Mader und H. Friedrich, Technologie hochintegrierter Schaltungen, Springer-Verlag, 1988, Abschnitte 3.1.4 und 3.9.1 verwiesen. Silizide sind Metall/Siliziumverbindungen, die in der Siliziumtechnologie als temperaturstabile niederohmige Leitbahnen, beispielsweise als Bitleitung, und Kontakte Verwendung finden. Die Silizidschichten sind typisch 0,1 bis 0,2 µm dick.

Sputterverfahren (Kathodenzerstäubung), bei denen ein Halbleitersubstrat mit einer Schicht belegt wird, deren Zusammensetzung der Zusammensetzung des Sputtertargets entspricht, haben sich in der Siliziumtechnologie bei vielen Anwendungen durchgesetzt. Silizide werden bisher vorzugsweise hergestellt durch Sputtern von einem Sintertarget (Mischtarget), einem Segmenttarget (Mosaiktarget) oder von einem Metall- und einem Siliziumtarget durch Cosputtern. Beim Cosputtern werden jeweils wechselweise durch mehrmaliges Vorbeibewegen an einem Metall- und einem Siliziumtarget dünne Lagen der Metall- und Siliziumschicht erzeugt. Bei all diesen Verfahren ist die Belastung durch verunreinigende Partikel relativ hoch. Dadurch wird bei der Herstellung von höchstintegrierten Halbleiterbausteinen die Ausbeute wesentlich reduziert. Beim Sputtern von einem Segmenttarget, welches aus Silizium und Metallstücken zusammengesetzt ist, werden die Partikel durch die Reibung der einzelnen Stücke gegeneinander verursacht. Beim Sintertarget ist die Partikelgenerierung hauptsächlich auf die Dichte, die Reinheit und, besonders stark, auf die Korngröße des Targets zurückzuführen. Gerade die hinsichtlich der Partikelgenerierung geeigneten Sintertargets sind jedoch in der Herstellung kritisch und sehr kostenaufwendig. Auch die ebenfalls bekannten reinen CVD-Abscheideverfahren zur Herstellung von Silizidschichten sind aufgrund der dort eingesetzten Ausgangsmaterialien, beispielsweise Wolframhexafluorid, kostenaufwendig. Unvorteilhaft ist auch der geringe Durchsatz von meist weniger als 10 Scheiben pro Stunde bei reinen CVD-Verfahren.

Der vorliegenden Erfindung liegt die Aufgabe zugrunde, ein Verfahren der eingangs angegebenen Art zu schaffen, das gegenüber den bekannten Verfahren verbessert ist.

Diese Aufgabe wird bei einem Verfahren der eingangs angegebenen Art dadurch gelost, daß in einer Prozeßkammer, die das Halbleitersubstrat und ein Sputtertarget aus Metall enthält, eine CVD-Abscheidung von Silizium aus der Gasphase erfolgt und daß eine amorphe Silizidschicht durch gleichzeitiges oder nachfolgendes Sputtern von dem Metalltarget hergestellt wird.

Weiterbildungen der Erfindung sind Gegenstand von Unteransprüchen. Im folgenden wird die Erfindung anhand eines Ausführungsbeispieles naher erläutert.

Metalltargets sind wesentlich billiger in der Herstellung (∼Faktor 10) und erzeugen weniger Partikel als Sintertargets (∼Faktor 10). Durch gleichzeitiges oder wechselweises PVD Abscheiden (Sputtern) von einem Metalltarget und CVD Abscheiden von Silizium aus der Gasphase ist es möglich, eine Metall/Silizium Mischschicht herzustellen. Die Herstellung von Silizidschichten mit diesem Verfahren generiert weniger Partikel (Metalltarget), ist kostengünstiger, reiner in der Schichtzusammensetzung (Targetreinheit) und steigert dadurch die Ausbeute.

Beim Sputtern wird in einer Prozesskammer zwischen einem Target (Metall z. B Molybdän) und einer Anode durch Anlegen einer Spannung und Hinzugabe eines Gases (innert oder reaktiv) ein Plasma gezündet. Gasionen werden dabei auf das negativ geladene Target beschleunigt und schlagen aus diesem einzelne Atome heraus, welche sich dann auf der gegenüberliegenden Siliziumscheibe niederschlagen. Wird nun in die Prozesskammer ein Si-haltiges Gas oder Gasgemisch z. B. SiH₄ und Ar eingebracht und am Metalltarget, z. B. Molybdän, eine negative Spannung angelegt, entsteht ein Plasma aus ionisierten SiH₄⁺ und Ar⁺-Ionen. Diese werden von der negativ geladenen Kathode angezogen, wobei das SiH₄⁺ an der Targetoberfläche dissoziert. Dabei reagiert das Silizium des SiH₄⁺ an der Oberfläche mit dem Targetmaterial und Wasserstoff wird frei. Die so erzeugte Silizidschicht an der Targetoberfläche wird durch die Ar⁺-ionen in bekannter Weise abgesputtert und auf dem Wafer abgeschieden. Neben der Silizidbildung auf dem Sputtertarget findet auch auf dem Substrat, besonders bei erhöhter Temperatur eine thermisch aktivierte Siliziumabscheidung statt, wobei Silanmoleküle oder im Plasma zerlegte Fragmente des siliziumhaltigen Gases zur Abscheidung kommen. Durch Variation der Sputterleistung,Substrattemperatur und Gaszusammensetzung ist es möglich, die Stöchiometrie der Silizidschicht einzustellen. Die amorphen Silizidschichten werden, wie üblich, anschließend zu feinkristallinen Silizidschichten getempert.

## Patentansprüche

1. Verfahren zum Sputtern von Siliziden bei der Herstellung von hochintegrierten Schaltungen auf einem Halbleitersubstrat,
**dadurch gekennzeichnet,** daß
in einer Prozeßkammer, die das Halbleitersubstrat und ein Sputtertarget aus Metall enthalt, eine CVD-Abscheidung von Silizium aus der Gasphase erfolgt und daß eine amorphe Silizidschicht durch gleichzeitiges oder nachfolgendes Sputtern von dem Metalltarget hergestellt wird.

2. Verfahren nach Anspruch 1,
**dadurch gekennzeichnet,** daß
ein aus Silan und Argon bestehendes Gasgemisch zur Generierung eines Plasmas in der Prozeßkammer verwendet wird.

3. Verfahren nach Anspruch 1 oder 2,
**dadurch gekennzeichnet,** daß
die Stöchiometrie der Silizidschicht durch Variation der Sputterleistung, der Substrattemperatur und der Gaszusammensetzung eingestellt wird.
